# EUROPÄISCHE PATENTSCHRIFT

(11) **EP 0 939 494 B1**
(45) Veröffentlichungstag und Bekanntmachung des Hinweises auf die Patenterteilung: **28.04.2004**
(21) Anmeldenummer: 99200453.1
(22) Anmeldetag: 16.02.1999
(51) Int. Cl.: H03M 1/10, H03M 1/70

(54) **Schaltungsanordnung mit Strom-Digital-Analog-Konvertern**
Circuit arrangement with current type digital to analogue converters
Montage de convertisseurs numériques-analogiques du type à courant

(30) Priorität: 25.02.1998 DE 19807856
(43) Veröffentlichungstag der Anmeldung: 01.09.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Meyer, Robert, Röntgenstrasse 24, 22335 Hamburg (DE); Pfarrkircher, Othmar, Röntgenstrasse 24, 22335 Hamburg (DE)
(74) Vertreter: von Laue, Hanns-Ulrich, Dipl.-Ing.

(56) Entgegenhaltungen:
- EP-A- 0 780 986
- US-A- 4 982 192
- US-A- 5 517 191
- US-A- 5 570 090

## Beschreibung

Die Erfindung betrifft eine Schaltungsanordnung mit Strom-DigitaI-Analog-Konvertern, deren Ausgangsamplitude von dem Wert eines digitalen Datenwortes abhängig ist und deren Ausgangsamplitudenbereich von dem Wert eines ihnen zugeführten Biasstromes abhängig ist.

Bei Strom-Digital-Analog-Konvertern wird ein digitales Datenwort in den analogen Bereich umgesetzt. Dies bedeutet, daß abhängig von dem digitalen Wert des Datenwortes ein analoger Ausgangsstrom erzeugt wird. Je nach sich ändernden Datenworten ändert sich auch in entsprechender Weise der Wert des Ausgangsstroms.

Zusätzlich ist es aus der US 5,570,090 bekannt, den Biasstrom, der dem Strom-Digital-Analog-Konverter zugeführt wird, in Abhängigkeit eines Steuer-Datenwortes zu variieren. Durch entsprechende Wahl des Wertes dieses Biasstromes, der ansonsten konstant ist, kann der Ausgangsamplitudenbereich, der in Abhängigkeit der Werte der Datenworte möglich ist, eingestellt werden. Es kann damit quasi eine Art Skalierung vorgenommen werden.

Es ist Aufgabe der Erfindung, eine Schaltungsanordnung mit mehreren Strom-Digital-Analog-Konvertern anzugeben, welche auf möglichst einfache Weise sowohl einen Abgleich der Biasströme für mehrere Strom-Digital-Analog-Konverter gestattet und außerdem eine Einstellmöglichkeit für den Ausgangsamplitudenbereich wenigstens eines der Strom-Digital-Analog-Konverter vorsieht.

Diese Aufgabe ist erfindungsgemäß dadurch gelöst, daß wenigstens eine Schaltung zur Erzeugung von abgeglichenen Biasströmen vorgesehen ist, deren Werte in Abhängigkeit wenigstens eines ersten Datenwortes variierbar sind,
daß wenigstens einem der Strom-Digital-Analog-Konverter eine Schaltung zur Einstellung des Ausgangsamplitudenbereichs zugeordnet ist, welcher einer der abgeglichenen Biasströme zugeführt wird und welche einen gewichteten Biasstrom für den ihr zugeordneten Strom-Digital-Analog-Konverter liefert,
daß denjenigen Strom-Digital-Analog-Konvertern, denen keine Schaltung zur Einstellung des Ausgangsamplitudenbereichs zugeordnet ist, einer der abgeglichenen Biasströme zugeführt wird,
daß in den Schaltungen zur Einstellung des Ausgangsamplitudenbereichs der ihnen jeweils zugeführte abgeglichene Biasstrom in Abhängigkeit eines jeweils zugeordneten zweiten Datenwortes variierbar ist, so daß der gewichtete Biasstrom entsteht, welcher dem jeweils zugeordneten Strom-Digital-Analog-Konverter zugeführt wird.

Der Biasstrom, der den Ausgangsamplitudenbereich von Strom-Digital-Analog-Konvertern bestimmt, ist grundsätzlich konstant zu wählen. Der Wert dieses Biasstromes kann jedoch nur aus Schaltungen abgeleitet werden, die ihrerseits Schwankungen der Werte der Bauelemente, beispielsweise bedingt durch Prozeßschwankungen bei der Herstellung von IC's unterworfen sind. So kann beispielsweise der Biasstrom aus einer Bandgap-Spannung abgeleitet werden, die zwar grundsätzlich relativ konstant ist, jedoch auch einer Toleranz von ± 3 % unterworfen sein kann.

Um auch diese Toleranz auszugleichen ist in der erfindungsgemäßen Anordnung eine Schaltung zur Erzeugung von abgeglichenen Biasströmen vorgesehen. Diese Schaltung erzeugt im Regelfall für alle auf der Schaltungsanordnung vorgesehenen Strom-Digital-Analog-Konverter jeweils gleiche Biasströme. Da wie oben erläutert, die Biasströme möglicherweise nicht immer den gewünschten Wert haben, ist es vorgesehen, die Werte der Biasströme in Abhängigkeit eines ersten Datenwortes zu variieren. Damit ist es möglich, die Biasströme exakt auf einen Sollwert einzustellen, der unabhängig von Prozeßschwankungen bzw. Schwankungen der Werte beteiligter Bauelemente ist. Dies ist zunächst eine wesentliche Voraussetzung, die gewünschte Arbeitsweise der Strom-Digital-Analog-Konverter sicherzustellen. Das heißt es ist zunächst sichergestellt, daß sich der Ausgangsamplitudenbereich der Strom-Digital-Analog-Konverter in Abhängigkeit der Werte der Datenworte in einem Sollbereich bewegt. Dieser Ausgangsamplitudenbereich ist für alle diejenigen Strom-Digital-Analog-Konverter gleich, denen einer der abgeglichenen Biasströme zugeführt wird, die von der Schaltung zur Erzeugung von abgeglichenen Biasströmen erzeugt werden.

Darüber hinaus eröffnet die erfindungsgemäße Schaltungsanordnung die Möglichkeit, für die Strom-Digital-Analog-Konverter individuell deren Ausgangsamplitudenbereich einzustellen. Dies geschieht mittels Schaltungen zur Einstellung des Ausgangsamplitudenbereichs. Es ist wenigstens eine derartige Schaltung vorgesehen. Jede dieser Schaltungen ist jeweils individuell einem Strom-Digital-Analog-Konverter fest zugeordnet und stellt dessen Ausgangsamplitudenbereich ein. Dies geschieht dadurch, daß der der Schaltung zur Einstellung des Ausgangsamplitudenbereiches zugeführte abgeglichene Biasstrom, der von der Schaltung zur Erzeugung von abgeglichenen Biasströmen kommt, seinerseits verändert wird. Dieser Biasstrom wird in einen gewichteten Biasstrom überführt, der dem zugeordneten Strom-Digital-Analog-Konverter zugeführt wird. Die Überführung des abgeglichenen Biasstromes in den gewichteten Biasstrom geschieht in Abhängigkeit eines jeweils den Schaltungen individuell zugeordneten zweiten Datenwortes. Damit ist in Abhängigkeit des Wertes des zweiten Datenwortes der abgeglichene Biasstrom variierbar, so daß der gewichtete Biasstrom entsteht. Damit ist, ausgehend von den einen konstanten Sollwert aufweisenden abgeglichenen Biasströmen individuell für jeden Strom-Digital-Analog-Konverter eine Einstellung des Ausgangsamplitudenbereiches in Abhängigkeit eines zweiten Datenwortes möglich.

Darüber hinaus weist die Schaltungsanordung den Vorteil auf, daß für mehrere Konverter gemeinsam ein Abgleich der Biasströme möglich ist. Das heißt die Schaltungsanordnung zur Erzeugung von abgeglichenen Biasströmen ist nur einmal vorzusehen. Dennoch ist es möglich, die Ausgangsamplitudenbereiche der Strom-Digital-Analog-Konverter individuell einzustellen. Durch die gemäß Anspruch 2 vorgesehene Ausgestaltung der Erfindung wird innerhalb der Schaltung zur Erzeugung der abgeglichenen Biasströme durch die Beschaltung des Operationsverstärkers und die darin vorgesehene Rückkopplung erreicht, daß das Ausgangssignal des Operationsverstärkers einen konstanten Wert annimmt, der einerseits abhängig von der Vergleichsspannung und andererseits abhängig von der über den Referenzwiderstand abfallenden Spannung ist. Durch entsprechende Wahl entweder der Vergleichsspannung und/oder des Wertes des Referenzwiderstandes kann somit die Ausgangsamplitude des Operationsverstärkers in gewünschter Weise eingestellt werden. Da jedoch sowohl der Wert der Vergleichsspannung wie auch der Wert des Referenzwiderstandes infolge von Bauteileschwankungen nicht immer die gewünschten Werte aufweisen, können dem Referenzstrom, der durch den Referenzwiderstand fließt, schaltbar gewichtete Ströme überlagert werden, deren Werte von dem Wert des ersten Steuerdatenwortes abhängig sind. Damit kann an dem Referenzwiderstand ein entsprechend differierender Spannungsabfall eingestellt werden, der zu einer entsprechend angepaßten Ausgangsamplitude des Operationsverstärkers führt. Somit ist dessen Ausgangssignal in Abhängigkeit der ersten Steuerdatenworte einstellbar. Diese Einstellung dient zunächst dazu, abgeglichene Biasströme für alle auf der Schaltungsanordnung vorgesehene Strom-Digital-Analog-Konverter zu generieren, welche vorzugsweise jeweils gleiche Größe haben und welche insbesondere einen konstanten Sollwert aufweisen.

Gemäß einer weiteren Ausgestaltung der Erfindung nach Anspruch 3 können vorteilhaft MOS-Stromspiegel zur Erzeugung der gewichteten Ausgangsströme vorgesehen sein.

Eine besonders vorteilhafte Regelmöglichkeit ergibt sich durch die weitere Ausgestaltung nach Anspruch 4, da hierdurch eine Variation des Referenzstromes, der durch den Referenzwiderstand fließt, mit unterschiedlichem Vorzeichen, d.h. also mit positivem oder negativem Vorzeichen möglich ist, so daß die abgeglichenen Biasströme sowohl nach oben wie auch nach unten in Abhängigkeit des Wertes des ersten Steuerdatenwortes korrigierbar sind.

Die so generierten abgeglichenen Biasströme werden, soweit vorgesehen, Schaltungen zur Einstellung des Ausgangsamplitudenbereiches zugeführt. Diese können vorzugsweise entsprechend Anspruch 5 aufgebaut sein. Auch hier werden MOS-Stromspiegel eingesetzt, mittels derer einerseits ein identisch mit dem Eingangsstrom ausgelegter Biasstrom erzeugt wird. Diesem werden weitere schaltbare gewichtete Ströme überlagert, so daß eine entsprechende Veränderung des abgeglichenen Biasstroms möglich ist. Die schließlich überlagerten Ströme ergeben die gewichteten Biasströme, die jeweils dem zugeordneten Strom-Digital-Analog-Konverter zugeführt werden. Damit ist in Abhängigkeit der zweiten Steuerdatenworte eine Variation der Biasströme in der Weise möglich, daß der gewünschte Ausgangsamplitudenbereich des jeweils zugeordneten Strom-Digital-Analog-Konverters einstellbar ist.

Eine weitere Ausgestaltung gemäß Anspruch 6 bietet den Vorteil, daß die Ausgangsamplitudenbereiche aller Strom-Digital-Analog-Konverter einstellbar sind. Die Abgleich- bzw. Einstellmöglichkeiten, die sich einerseits durch die Schaltungsanordnung zur Erzeugung von abgeglichenen Biasströmen und andererseits durch die Schaltungen zur Einstellung der Ausgangsamplitudenbereiche ergeben, werden vorzugsweise gemäß den weiteren Ausgestaltungen nach Anspruch 7 und 8 eingesetzt.

Die erfindungsgemäße Schaltungsanordnung hat außer der einfachen Erzeugung der gemeinsamen abgeglichenen Biasströme den Vorteil, daß der Ausgangsamplitudenbereich jedes Strom-Digital-Analog-Konverters einstellbar ist. Dies ist insbesondere für Einsatzzwecke vorteilhaft, bei denen in Abhängigkeit der Datenworte verschiedene Ausgangssignale mit verschiedenen Amplituden erzeugt werden sollen. Dies kann vorteilhaft insbesondere zur Konvertierung von Bildsignalen eingesetzt werden, da hier oftmals verschiedene Kategorien von Bildsignalen mit verschiedenen Amplitudenbereichen zu erzeugen sind. Eine vorteilhafte Ausgestaltung für diesen Einsatzzweck ist in Anspruch 9 angegeben.

Nachfolgend wird ein Ausführungsbeispiel der Erfindung näher erläutert. Es zeigen:
Fig. 1 ein Blockschaltbild einer erfindungsgemäßen Schaltungsanordnung mit mehreren Strom-Digital-Analog-Konvertern, denen jeweils eine Schaltung zur Einstellung des Ausgangsamplitudenbereiches zugeordnet ist,
Fig. 2 ein Schaltbild einer Schaltung zur Erzeugung von abgeglichenen Biasströmen, wie sie beispielsweise in der Schaltung gemäß Fig. 1 vorgesehen sein kann und
Fig. 3 eine Schaltung zur Einstellung des Ausgangsamplitudenbereiches, wie sie beispielsweise in der Schaltung gemäß Fig. 1 vorgesehen sein kann.

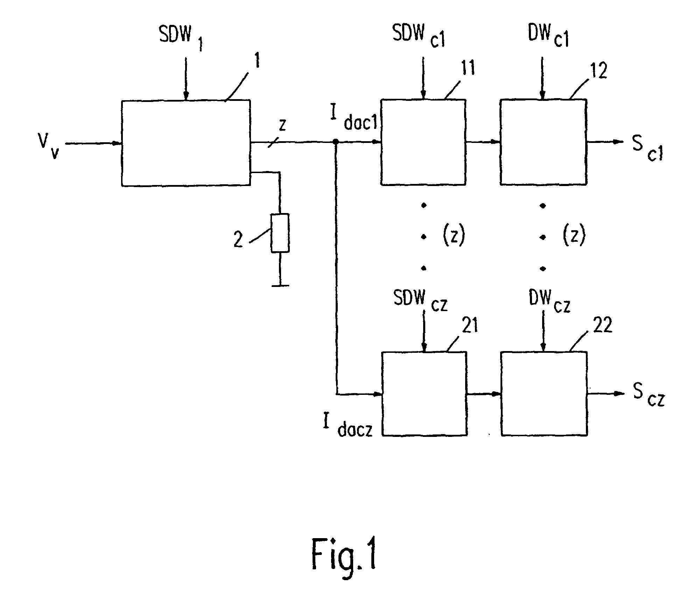

Das in Fig. 1 dargestellte Blockschaltbild zeigt eine Schaltung 1 zur Erzeugung von abgeglichenen Biasströmen. Dieser Schaltung 1 werden eingangsseitig sowohl eine Vergleichsspannung V_{V} sowie auch ein erstes Steuerdatenwort SDW₁ zugeführt. Ferner ist die Schaltung 1 einem extern vorgesehenen Referenzwiderstand 2 gekoppelt. Die Schaltung 1 erzeugt in weiter unten näher zu erläuternder Weise einen Referenzstrom, der durch diesen Referenzwiderstand 2 fließt. In Abhängigkeit des infolge dieses Stromes über dem Referenzwiderstand 2 abfallenden Spannung und dem Wert der Vergleichsspannung V_{V} werden abgeglichene Biasströme I_{dac1} bis I_{dacz} erzeugt, deren Anzahl von der Zahl z der in der Anordnung vorgesehenen Strom-Digital-Analog-Konverter abhängt.

Da der Wert der abgeglichenen Biasströme I_{dac1} bis I_{dacz} sowohl von dem Wert des Referenzwiderstandes 2, der Schwankungen unterworfen sein kann, wie auch dem Wert der Vergleichsspannung V_{V} abhängig ist, ist eine Abgleichmöglichkeit der Biasströme vorgesehen. Diese bewirkt, daß in Abhängigkeit des Wertes des ersten Steuerdatenwortes SDW₁ die abgeglichenen Biasströme I_{dac1} bis I_{dacz} bezüglich ihres Wertes so variierbar sind, daß sie auf einen Sollwert einstellbar sind. Der Wert des ersten Steuerdatenwortes SDW₁ wird also so gewählt, daß die abgeglichenen Biasströme I_{dac1} bis I_{dacz} immer die Sollwerte aufweisen, die auch dann erreicht werden, wenn der Referenzwiderstand 2 oder die Vergleichsspannung V_{V} nicht die gewünschten Werte aufweisen. Die so erzeugten abgeglichenen Biasströme stellen sicher, daß die nachgeschalteten Strom-Digital-Analog-Konverter die ihnen jeweils zugeführten Datenworte exakt in die gewünschten Amplitudenwerte am Ausgang umsetzen.

Es besteht die Möglichkeit, wenigstens einigen der vorgesehenen Strom-Digital-Analog-Konverter diese abgeglichenen Biasströme direkt zuzuführen. Erfindungsgemäß ist jedoch wenigstens eine Schaltung 11 zur Einstellung des Ausgangsamplitudenbereiches vorgesehen. Dieser Schaltung 11 wird der zugeordnete abgeglichene Biasstrom I_{dac1} zugeführt. Dieser wird in der Schaltung 11 in Abhängigkeit eines zugeordneten zweiten Steuerdatenwortes SDW_{C1} variierbar. Auf diese Weise wird ein gewichteter Biasstrom erzeugt, der dem der Schaltung 11 zugeordneten Strom-Digital-Analog-Konverter 12 zugeführt wird. Die Schaltung 11 gestattet es somit, den abgeglichenen Biasstrom I_{dac1} dahingehend zu variieren, daß in Abhängigkeit des zweiten Steuerdatenwortes SDW_{C1} dieser Biasstrom veränderbar ist zu dem gewichteten Biasstrom. Damit kann für den Strom-Digital-Analog-Konverter 12 eine individuelle Einstellung von dessen Ausgangsamplitudenbereich vorgenommen werden. Die aktuelle Amplitude des Ausgangssignals S_{C1} des Strom-Digital-Analog-Konverters 12 ist ansonsten abhängig von dem eigentlichen zu konvertierenden Datenwort DW_{C1}. Dieses zu konvertierende Datenwort bestimmt die momentane Ausgangsamplitude. Der insgesamt in Abhängigkeit dieser Datenworte überstrichene Ausgangsamplitudenbereich wird mittels der gewichteten Biasströme bestimmt.

In dem Ausführungsbeispiel gemäß Fig. 1 ist jedem der vorgesehenen Strom-Digital-Analog-Konverter jeweils eine Schaltung zur Einstellung des Ausgangsamplitudenbereiches vorgeschaltet. Diese Schaltungen zur Einstellung des Ausgangsamplitudenbereiches sind dem jeweiligen Strom-Digital-Analog-Konverter fest zugeordnet.

So ist in der Fig. 1 ein zweiter Strom-Digital-Analog-Konverter 22 vorgesehen, dem ein zu konvertierendes Datenwort DW_{CZ} zugeführt wird. Dem Strom-Digital-Analog-Konverter 22 fest zugeordnet ist eine Schaltung 21 zur Einstellung dessen Ausgangsamplitudenbereiches. Dieser Schaltung 21 wird ein fest zugeordnetes zweites Steuerdatenwort SDW_{CZ} zugeführt.

In dem Blockschaltbild gemäß Fig. 1 sind zwei Strom-Digital-Analog-Konverter 12 und 22 dargestellt; es können jedoch noch weitere vorgesehen sein.

Die auf den Sollwert abgeglichenen Biasströme sind durch die jeweils zugeordneten Schaltungen 11 und 22 (und gegebenenfalls die Schaltungen, die weiteren gegebenenfalls vorgesehenen Strom-Digital-Analog-Konvertern zugeordnet sind) zu den gewichteten Biasströmen variierbar, wobei diese Einstellung individuell für jeden Strom-Digital-Analog-Konverter 11 und 22 vorgenommen wird, da den jeweiligen Schaltungen 11 bzw. 21 zur Einstellung des Ausgangsamplitudenbereiches individuell gewählte Steuerdatenworte SDW_{C1} bzw. SDW_{CZ} zugeführt werden.

Die Schaltung gemäß Fig. 1 kann beispielsweise für die Konvertierung von digitalen Videosignalen in analoge Videosignale vorgesehen sein. Im analogen Bereich sind für verschiedene Typen von Videosignalen verschiedene Spannungshübe vorgesehen. So kann mittels der Schaltungen 11 und 21 zur Einstellung des Ausgangsamplitudenbereiches die Spannungshübe, die an Widerständen auftreten, über die die Ausgangsströme S_{C1} und S_{CZ} geleitet werden, eingestellt werden. Beispielsweise für Video-RGB-Signale ist ein Spannungshub von 1 V, für Video-YC-Signale ein Spannungshub von 1,16 V und für Video-CVBS-Signale ein Spannungshub von 1,23 V erwünscht. Diese an externen, in der Fig. 1 nicht dargestellten Widerständen abfallenden Spannungshübe sind mittels der zweiten Steuerdatenworte SDW_{C1} bis SDW_{CZ} einstellbar. Damit gelingt es in der erfindungsgemäßen Schaltungsanordnung trotz eines gemeinsamen Abgleichs der Biasströme und einer gemeinsamen Erzeugung der abgeglichenen Biasströme dennoch für jeden der Strom-Digital-Analog-Konverter einen individuellen Ausgangsamplitudenbereich einzustellen.

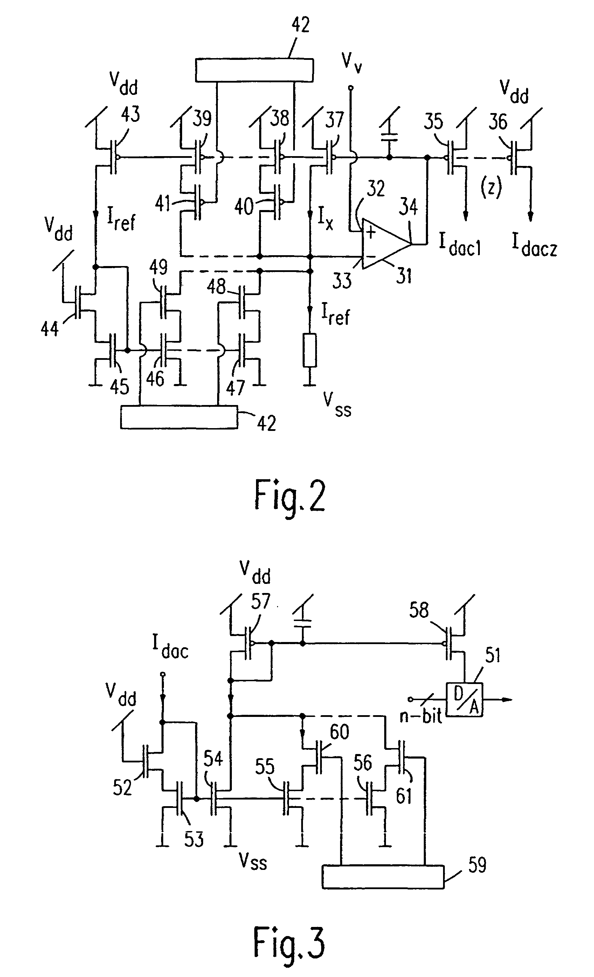

In Fig. 2 ist eine Schaltung zur Erzeugung der abgeglichenen Biasströme dargestellt, wie sie beispielsweise in dem Block 1 gemäß Fig. 1 vorgesehen sein kann.

In der Schaltung gemäß Fig. 2 ist ein Operationsverstärker 31 vorgesehen, dessen nicht invertierendem Eingang 32 die Vergleichsspannung V_{V} zugeführt wird. Ein invertierender Eingang 33 des Operationsverstärkers 31 ist mit dem extern vorgesehenen Referenzwiderstand 2 gekoppelt, der seinerseits gegen ein Bezugspotential geschaltet ist. Durch den Referenzwiderstand 2 fließt ein variierbarer Referenzstrom I_{ref}.

Ein Ausgang 34 des Operationsverstärkers 31 liefert eine Ausgangsspannung, die auf die Gate-Anschlüsse von PMOS-Transistoren 35 und 36 geführt ist. Die Source-Anschlüsse dieser PMOS-Transistoren 35 und 36 sind gegen eine Versorgungsspannung V_{dd} geschaltet. Die Drain-Anschlüsse dieser PMOS-Transistoren 35 und 36 liefern die abgeglichenen Biasströme I_{dac1} und I_{dacz} wie sie in Fig. 1 eingetragen sind.

Der Ausgang 34 ist ferner auf einen Gate-Anschluß eines weiteren PMOS-Transistors 37 gekoppelt, dessen Source-Anschluß ebenfalls gegen das Bezugspotential V_{dd} geschaltet ist und dessen Drain-Anschluß einen Strom Iₓ liefert, der den Basisanteil für den Strom I_{ref}, der durch den extern vorgesehenen Referenzwiderstand 2 fließt, darstellt.

Diese soweit erläuterte Schaltung des Operationsverstärkers 31 würde noch keine Variation der abgeglichenen Biasströme I_{dac1} und I_{dac2} gestatten. Hierzu ist die weitere Beschaltung vorgesehen.

Der Ausgang 34 des Operationsverstärkers 31 ist mit Gate-Anschlüssen weiterer PMOS-Transistoren 38 und 39 gekoppelt. Die Source-Anschlüsse der Transistoren 38 und 39 sind gegen das Versorgungspotential V_{dd} und deren Drain-Anschlüsse mit Source-Anschlüssen weiterer PMOS-Transistoren 40 und 41 gekoppelt. Die Gate-Anschlüsse der Transistoren 40 und 41 werden in Abhängigkeit eines in der Figur symbolisch dargestellten ersten Steuerdatenwortes 42 geschaltet. Die Drain-Anschlüsse der Transistoren 40 und 41 liefern somit Ströme, die einerseits von dem Wert der Ausgangsamplitude am Ausgang 34 des Operationsverstärkers 31 abhängig sind, da die Drain-Anschlüsse der Transistoren 38 und 39 ein von dieser Ausgangsamplitude abhängiges Signal liefern. Die Drain-Signale der Transistoren 38 und 39 werden mittels der Transistoren 40 und 41 geschaltet. Dieses Schalten geschieht in Abhängigkeit des Wertes des ersten Steuerdatenwortes 42. Insbesondere können dabei die Flächen der Transistoren 38 und 39 so gestaltet sein, daß sie gewichtete Ströme liefern. Diese Gewichtung kann beispielsweise so gestaltet sein, daß die Ströme entsprechend der Gewichtung der jeweiligen Bits des ersten Steuerdatenwortes 42 gestaltet sind. Hat beispielsweise dasjenige Bit des ersten Steuerdatenwortes 42, das auf den Transistor 41 gekoppelt ist, die doppelte Wertigkeit desjenigen Bits, was auf den Schalter 40 gekoppelt ist, so ist vorteilhaft auch der Strom, den der Transistor 39 liefert, doppelt so groß gewählt wie derjenige, den der Transistor 38 liefert.

Die durch die als Schalter eingesetzten PMOS-Transistoren 40 und 41 gelieferten Ströme überlagern sich gleichsinnig dem Strom Iₓ. Es gelingt somit in Abhängigkeit des Wertes des ersten Steuerdatenwortes den Strom I_{ref} zu variieren. Es können weitere entsprechend verschaltete PMOS-Transistoren 38 und 39 sowie entsprechend zugeordnete Schalter 40 und 41 vorgesehen sein, deren Zahl beispielsweise von der Bitbreite des ersten Steuerdatenwortes 42 abhängig ist.

Die insoweit erläuterte Schaltung erlaubt ein Variieren des Stromes I_{ref} in gleichsinniger Richtung, d.h. der Strom I_{ref} ist in positiver Richtung variierbar. Der nachfolgend erläuterte Schaltungsteil der Schaltung gemäß Fig. 2 gestattet darüber hinaus ein Variieren des Stromes I_{ref} in negativer Richtung, also ein Verkleinern des Referenzstromes.

Hierzu ist ein weiterer PMOS-Transistor 43 vorgesehen, welcher ebenfalls sourceseitig mit dem Versorgungspotential V_{dd} gekoppelt ist. Der Drain-Anschluß des PMOS-Transistors 43 ist auf eine Stromspiegelschaltung gekoppelt, die eingangsseitig mittels NMOS-Transistoren 44 und 45 und ausgangsseitig mittels NMOS-Transistoren 46 und 47 gebildet ist.

Das von dem Drain-Anschluß des PMOS-Transistors 43 gelieferte Signal ist auf den Source-Anschluß des Transistors 44, dessen Gate mit dem Versorgungspotential V_{dd} gekoppelt ist, und dem Gate des NMOS-Transistors 45 gekoppelt, dessen Drain-Anschluß mit Bezugspotential gekoppelt ist. Ferner ist der Drain-Anschluß des NMOS-Transistors 44 mit dem Source-Anschluß des NMOS-Transistors 45 gekoppelt. Der Gate-Anschluß ist auf die Gate-Anschlüsse der Transistoren 46 und 47 gekoppelt, deren Drain-Anschlüsse mit Bezugspotential gekoppelt sind. Durch die Verschaltung mittels des Transistors 43 und die Stromspiegelschaltung ist sichergestellt, daß die Transistoren 46 und 47 Ströme gleicher Größe wie die Transistoren 38 und 39 liefern. Auch hier ist es vorteilhaft, daß die Transistoren 47 und 46 gewichtete Ströme liefern, die vorteilhaft in Abhängigkeit des jeweils zugeordneten Bits des Steuerdatenwortes 42 gewählt sind. Die Source-Anschlüsse der NMOS-Transistoren 48 und 49 liefern einen negativen Beitrag zu dem Strom Iₓ und überlagern sich gemeinsam mit den von den Transistoren 38 und 40 sowie 39 und 41 gelieferten Ströme zu dem Gesamtstrom I_{ref}, der durch den Widerstand 2 fließt.

Die Arbeitsweise der Transistoren 46, 47 und 48, 49 ist die gleiche, wie diejenige der Transistoren 38, 39 und 40, 41, mit dem einzigen Unterschied, daß die von diesen Transistoren gelieferten Ströme eine Verringerung des Stromes I_{ref} bewirken.

Für die Transistoren 48 und 49 können spezielle Bits des Steuerdatenwortes 42 vorgesehen sein; es besteht auch die Möglichkeit, für diese Transistoren ein gesondertes Steuerdatenwort vorzusehen.

Im Ergebnis gelingt es somit, dem Strom Iₓ dahingehend Ströme unterschiedlichen Vorzeichens zu überlagern, daß der Strom I_{ref} variiert wird.

Ist die Vergleichssapnnung Vᵥ zu groß oder der Wert des Widerstandes 2 zu klein, führt dies zu einem zu großen Refernzstrom I_{ref} und damit zu zu großen Strömen I_{dac}. Umgekehrt sind diese Ströme zu klein, wenn Vᵥ zu klein oder der Widerstand 2 zu groß ist.

Durch die oben beschreibene Variation des Refernzstromes I_{ref} kann dies korrigiert werden, indem mittels Überlagerung der zusatzlichen Ströme die über den Widerstand 2 abfallende Spannung variiert wird. Damit ist es möglich, ggf. von den Sollwerten abweichende Werte der Versorgungsspannung Vᵥ oder des Widerstandswertes des Widerstandes 2 dahingehend zu korrigieren, daß die abgeglichenen Biasströme I_{dac1} und I_{dacz} die gewünschten Werte aufweisen, was ohne die Korrektur in Abhängigkeit des zweiten Steuerdatenwortes nicht der Fall wäre, da der Operationsverstärker 31 infolge des von dem Sollwert abweichenden Wertes der Versorgungsspannung oder des von einem Sollwert abweichenden Wertes des Spannungsabfalles über dem externen Widerstand 2 ein falsches Ausgangssignal liefern würde und somit die Ströme I_{dac1} bzw. I_{dacz} nicht in der gewünschten Größe entstehen würden. Über die geschalteten gewichteten Ströme kann jedoch der Spannungsfall über dem Widerstand 2 so variiert werden, daß die abgeglichenen Ströme I_{dac1} bzw. I_{dacz} die gewünschten Werte aufweisen. Vorzugsweise sind diese Werte gleich.

In Fig. 3 ist eine Schaltung zur Einstellung des Ausgangsamplitudenbereiches dargestellt, wie sie beispielsweise in dem Blockschaltbild gemäß Fig. 1 in den Blöcken 11 und 21 vorgesehen sein kann.

Der Schaltung wird eingangsseitig der jeweils zugeordnete Strom I_{dac} zugeführt. Dabei handelt es sich um den von der Schaltung 1 gemäß Fig. 1 erzeugten abgeglichenen Biasstrom. Dieser Strom kann beispielsweise mittels der Schaltung gemäß Fig. 2 erzeugt sein.

Innerhalb der Schaltung gemäß Fig. 3 zur Einstellung des Ausgangsamplitudenbereiches gelangt der Strom I_{dac} an einen ersten Stromspiegel, der mittels NMOS-Transistoren 52, 53 sowie ausgangsseitig 54, 55 und 56 aufgebaut ist. Die Verschaltung der eingangsseitigen Transistoren 52 und 53 des Stromspiegels entspricht derjenigen der Transistoren 44 und 45 des in des Schaltung gemäß Fig. 2 vorgesehenen Stromspiegels.

In der Fig. 3 liefert der Ausgangstransistor 54 des Stromspiegels einen Strom, der zu dem Eingangsstrom I_{dac} ein festes, bekanntes Verhältnis aufweist, in diesem Beispiel beträgt er 2 mal I_{dac}. Dieser Strom gelangt auf eine zweite Stromspiegelschaltung, die mittels eines eingangsseitig vorgesehenen PMOS-Transistors 57 und eines ausgangsseitigen PMOS-Transsitors 58 aufgebaut ist. Der Source-Anschluß des Ausgangstransistors 54 ist mit dem Drain-Anschluß des Transistors 57 sowie dessen Gate-Anschluß gekoppelt. Der Source-Anschluß des Transistors 57 mit Versorgungspotential gekoppelt. Die Gates der Transistoren 57 und 58 sind miteinander gekoppelt. Der Source-Anschluß des Transistors 58 ist mit Bezugspotential gekoppelt. Der Drain-Anschluß des Transistors 58 ist auf einen Strom-Digital-Analog-Konverter 51 gegeben, und liefert für diesen den Biasstrom, von dessen Wert der Ausgangsamplitudenbereich, der in Abhängigkeit von Datenworten, die dem Strom-Digital-Analog-Konverter zugeführt werden, überstrichen wird. Der Transistor 58 ist im Prinzip aus Einzeltransistoren aufgebaut, die in Abhängigkeit eines Datenwortes DW gewichtet schaltbar sind.

Der insoweit erläuterte Teil der Schaltung gemäß Fig. 3 erzeugt einen Biasstrom am Drain-Anschluß des Transistors 58, der ein bekanntes Verhältnis zu dem Strom I_{dac} aufweist, in diesem Falle dessen doppelten Wert. Insoweit hat also keine Veränderung dieses der Schaltung eingangsseitig zugeführten abgeglichenen Biasstromes stattgefunden. Hierzu ist die weitere Beschaltung vorgesehen.

In dem ersten Stromspiegel sind ausgangsseitig die Transistoren 55 und 56 dazu vorgesehen, gewichtete Ströme zu liefern. Dazu sind diese Transistoren entsprechend dem Transistor 54 verschaltet. Jedoch sind die Source-Anschlüsse der Transistoren 55 und 56 jeweils mit Drain-Anschlüssen weiterer Transistoren 60 und 61 gekoppelt, deren Gate-Anschlüsse mit zugeordneten Bits eines zugeordneten zweiten Steuerdatenwortes 59 gekoppelt sind. Das heißt, die Transistoren 60 und 61 werden in Abhängigkeit der Wertigkeit des jeweils zugeordneten Bits des zweiten Steuerdatenwortes 59 geschaltet. Die Source-Anschlüsse der Transistoren 60 und 61 sind ebenfalls auf den Eingang des zweiten Stromspiegels und somit auf den Drain-Anschluß und Gate-Anschluß des Transistors 57 gekoppelt.

Vorteilhaft sind die Flächen der Transistoren 55 und 56 so ausgelegt, daß sie gewichtete Ströme liefern, deren Gewichtung abhängig ist von der Gewichtung desjenigen Bits, in dessen Abhängigkeit der jeweils zugeordnete Transistor 60 bzw. 61 geschaltet wird.

Somit können dem Eingangsstrom des zweiten Stromspiegels in Abhängigkeit des zweiten Steuerdatenwortes 59 zusätzliche Ströme überlagert werden, welche eine Variation dieses Eingangsstromes erlauben.

Infolge einer Variation des Eingangsstromes des zweiten Stromspiegels variiert auch dessen Ausgangsstrom, der als gewichteter Biasstrom dem Strom-Digital-Analog-Konverter 51 zugeführt wird. Damit ist es möglich, den abgeglichenen Biasstrom I_{dac} in Abhängigkeit des Wertes des zweiten Steuerdatenwortes 59 so zu verändern, daß ein gewichteter Biasstrom entsteht. Dieser wiederum kann so ausgelegt sein, daß für den individuell zugeordneten Strom-Digital-Analog-Konverter 51 ein gewünschter Amplitudenbereich von dessen Ausgangssignal einstellbar ist.

Wie oben bereits für gemäß Fig. 1 erläutert wurde, kann diese Gewichtung individuell vorgenommen werden, so daß es beispielsweise für Videoanwendungen möglich ist, für verschiedene Arten von zu erzeugenden analogen Videosignalen verschiedene Hübe einzustellen.

Die Schaltung des Ausführungsbeispiels kann auch invers aufgebaut werden, sodaß der ausgangsstrom des Konverters 51 nicht gegen das Bezugspotential Vₛₛ sondern gegen das Versorgungspotential V_{dd} fließt. In diesem Falle würden beispielsweise die Transistoren 57 und 58 N-MOS-Transistoren.

Zur Symmetrierung können zwischen die Transistoren 43 und 44 sowie zwischen die Transitoren 54 und 57 Transistoren entspechend den Transistoren 40, 41 bzw. 60, 61 geschaltet werden, wodurch in diesen Pfaden gleiches Verhalten wie in den benachbarten Pfaden erzielt wird.

## Patentansprüche

1. Schaltungsanordnung mit Strom-Digital-Analog-Konvertern (12,22,...), deren Ausgangsamplitude von dem Wert eines digitalen Datenwortes abhängig ist und deren Ausgangsamplitudenbereich von dem Wert eines ihnen zugeführten Biasstromes abhängig ist, **dadurch gekennzeichnet,**
**daß** wenigstens eine Schaltung (1) zur Erzeugung von abgeglichenen Biasströmen vorgesehen ist, deren Werte in Abhängigkeit wenigstens eines ersten Datenwortes variierbar sind,
**daß** wenigstens einem der Strom-Digital-Analog-Konverter (12,22,...) eine Schaltung (11,21,...) zur Einstellung des Ausgangsamplitudenbereichs zugeordnet ist, welcher einer der abgeglichenen Biasströme zugeführt wird und welche einen gewichteten Biasstrom für den ihr zugeordneten Strom-Digital-Analog-Konverter (12,22,...) liefert,
**daß** denjenigen Strom-Digital-Analog-Konvertern (12,22,...), denen keine Schaltung (11,21,...) zur Einstellung des Ausgangsamplitudenbereichs zugeordnet ist, einer der abgeglichenen Biasströme zugeführt wird,
**daß** in den Schaltungen (11,21,...) zur Einstellung des Ausgangsamplitudenbereichs der ihnen jeweils zugeführte abgeglichene Biasstrom in Abhängigkeit eines jeweils zugeordneten zweiten Datenwortes variierbar ist, so daß der gewichtete Biasstrom entsteht, welcher dem jeweils zugeordneten Strom-Digital-Analog-Konverter (12,22,...) zugeführt wird.

2. Anordnung nach Anspruch 1, **dadurch gekennzeichnet,**
**daß** die Schaltung (1) zur Erzeugung der abgeglichenen Biasströme einen Operationsverstärker (31) aufweist, dessen nicht-invertierendem Eingang (32) eine Vergleichsspannung zugeführt wird und in Abhängigkeit von dessen Ausgangssignal die abgeglichenen Biasströme und ein Referenzstrom erzeugt werden, welcher durch einen Referenzwiderstand (2) fließt, dessen Spannungsabfall auf einen invertierenden Eingang (33) des Operationsverstärkers (31) gekoppelt ist, wobei zum Abgleich der vorzugsweise gleich großen abgeglichenen Biasströme in Abhängigkeit eines ersten Steuer-Datenwortes dem Referenzstrom schaltbare gewichtete Ströme überlagerbar sind.

3. Anordnung nach Anspruch 2, **dadurch gekennzeichnet,**
**daß** MOS-Stromspiegel (37,38,39,? 44,45,46,47) vorgesehen sind, deren gewichtete Ausgangsströme mittels MOS-Transistoren (40,41,48,49) in Abhängigkeit des ersten Steuer-Datenwortes schaltbar sind.

4. Anordnung nach Anspruch 2 oder 3, **dadurch gekennzeichnet,**
**daß** die in Abhängigkeit des ersten Steuer-Datenwortes schaltbaren gewichteten Ströme dem Referenzstrom mit gleichem und/oder verschiedenem Vorzeichen überlagerbar sind.

5. Anordnung nach Anspruch 1, **dadurch gekennzeichnet,**
**daß** in den Schaltungen (11,21,...) zur Einstellung des Ausgangsamplitudenbereichs der jeweils zugeführte abgeglichene Biasstrom einem MOS-Stromspiegel (52,53,54,55,56) zugeführt wird, innerhalb dessen ein Ausgangstransistor (54) den unveränderten abgeglichenen Biasstrom liefert und innerhalb dessen weitere Ausgangstransistoren (55,56) vorgesehen sind, welche in Abhängigkeit eines zugeordneten zweiten Steuer-Datenwortes und zugeordneten MOS-Transsitoren (60,61) schaltbare gewichtete Ströme liefern, welche dem abgeglichenen Biasstrom überlagert werden, so daß der gewichtete Biasstrom entsteht, welcher dem jeweils zugeordneten Strom-Digital-Analog-Konverter (12,22,...) zugeführt wird.

6. Anordnung nach Anspruch 1, **dadurch gekennzeichnet,**
**daß** jedem der Strom-Digital-Analog-Konverter (12,22,...) jeweils eine Schaltung (11,21,...) zur Einstellung des Ausgangsamplitudenbereichs zugeordnet ist und daß die abgeglichenen Biasströme gleiche Werte haben.

7. Anordnung nach Anspruch 1, **dadurch gekennzeichnet,**
**daß** das erste Steuer-Datenwort, das der Schaltung (1) zur Erzeugung der abgeglichenen Biasströme zugeführt wird, zur Korrektur der Werte der abgeglichenen Biasströme vorgesehen ist, falls diese in Folge von den Sollwerten abweichenden Werten der Referenzspannung und/oder des Referenzwiderstandes (2) von einem Sollwert abweichen.

8. Anordnung nach Anspruch 1, **dadurch gekennzeichnet,**
**daß** die den Strom-Digital-Analog-Konvertern (12,22,...) bzw. die den diesen zugeordneten Schaltungen (11,21,...) zur Einstellung des Ausgangsamplitudenbereichs zugeordneten zweiten Steuer-Datenworte zur Einstellung von Amplitudenbereichen vorgesehen sind, welche jeweils den Datenarten zugeordnet sind, welche die Strom-Digital-Analog-Konverter (12,22,...) konvertieren.

9. Anordnung nach Anspruch 8, **dadurch gekennzeichnet,**
**daß** die den Strom-Digital-Analog-Konvertern (12,22,...) bzw. den diesen zugeordneten Schaltungen (11,21,...) zur Einstellung des Ausgangsamplitudenbereichs zugeordneten zweiten Steuer-Datenworte so gewählt werden, daß der jeweils zugeordnete den Strom-Digital-Analog-Konverter (12,22,...) an einem nachgeschalteten Widerstand bei Verarbeitung eines Video-RGB-Signals einen Spannungshub von 1 Volt, bei Verarbeitung eines Video-Y/C-Signals einen Spannungshub von 1,16 Volt und bei Verarbeitung eines Video-CVBS-Signals einen Spannungshub von 1,23 Volt erzeugt.

10. Verwendung der Anordnung nach einem der Ansprüche 1 bis 9 zur Digital-Analog-Konvertierung eines Bildsignals.

## Claims

1. A circuit arrangement comprising digital-to-analog current converters (12, 22, ...) whose output amplitudes depend on the value of a digital data word and whose output amplitude ranges depend on the value of a bias current applied to the respective converter, **characterized in that**
at least one circuit (1) is provided for generating controlled bias currents whose values can be varied in dependence on at least a first data word,
at least one of the digital-to-analog current converters (12, 22, ...) is associated with a circuit (11, 21, ...) for setting the output amplitude range, to which one of the controlled bias currents is applied and which supplies a weighted bias current for its associated digital-to-analog current converter (12, 22, ...),
one of the controlled bias currents is applied to those of the digital-to-analog current converters (12, 22, ...) which are not associated with a circuit (11, 21, ...) for setting the output amplitude range, and
the controlled bias current applied to the circuits (11, 21, ...) for setting the output amplitude range can be varied therein in dependence on an associated second data word, which results in the weighted bias current which is applied to the associated digital-to-analog current converter (12, 22 ...).

2. A circuit arrangement as claimed in Claim 1, **characterized in that**
the circuit (1) for generating the controlled bias currents includes an operational amplifier (31) having a non-inverting input (32) to which a comparison voltage is applied and supplying an output signal in dependence on which the controlled bias currents and a reference current are generated, which reference current flows through a reference resistor (2) and produces a voltage drop which is coupled to an inverting input (33) of the operational amplifier (31), wherein switchable weighted currents can be superposed on the reference current in order to control the preferably equal controlled bias currents in dependence on a first control data word.

3. A circuit arrangement as claimed in Claim 2, **characterized in that**
MOS current mirrors (37, 38, 39, 44, 45, 46, 47) are provided whose weighted output currents are switchable by means of MOS transistors (40, 41, 48, 49) in dependence on the first control data word.

4. A circuit arrangement as claimed in Claim 2 or 3, **characterized in that**
the weighted currents which are switchable in dependence on the first control data word are superposable on the reference current with the same sign and/or with different signs.

5. A circuit arrangement as claimed in Claim 1, **characterized in that**
in the circuits (11, 21, ...) for setting the output amplitude range the controlled bias current received is applied to a MOS current mirror (52, 53, 54, 55, 56) in which an output transistor (54) supplies the unaltered controlled bias current and which includes further output transistors (55, 56) which supply weighted currents which are switchable in dependence on an associated second control data word and on associated MOS transistors, which weighted currents are superposed on the controlled bias current so as to form the weighted bias current, which is applied to the respective associated digital-to-analog current converter (12, 22, ...).

6. A circuit arrangement as claimed in Claim 1, **characterized in that**
each of the digital-to-analog current converters (12, 22, ...) is associated with a circuit (11, 21, ...) for setting the output amplitude range, and the controlled bias currents have equal values.

7. A circuit arrangement as claimed in Claim 1, **characterized in that**
the first control data word, which is applied to the circuit (1) for generating the controlled bias currents, serves for correcting the values of the controlled bias currents in the case that these values deviate from a nominal value owing to the reference voltage and/or the reference resistor (2) having values which deviate from a nominal value.

8. A circuit arrangement as claimed in Claim 1, **characterized in that**
the second control data words, which are associated with the digital-to-analog current converters (12, 22, ...) or with the circuits (11, 21 ...) for setting the output amplitude range which are associated with these converters, serve for setting amplitude ranges associated with data types converted by the digital-to-analog current converters (12, 22, ...).

9. A circuit arrangement as claimed in Claim 8, **characterized in that**
the second control data words, which are associated with the digital-to-analog current converters (12, 22, ...) or with the circuits (11, 21 ...) for setting the output amplitude range which are associated with these converters, are selected in such a manner that the associated digital-to-analog current converter (12, 22, ...) generates a voltage swing of 1 V when a video RGB signal is processed, a voltage swing of 1.16 V when a video Y/C signal is processed, and a voltage swing of 1.23 V when a video CVBS signal is processed, across a resistor arranged after this converter.

10. The use of the circuit arrangement as claimed in any one of the Claims 1 to 9 for the digital-to-analog conversion of a picture signal.

## Revendications

1. Montage de convertisseurs numériques-analogiques du type à courant (12, 22...) dont l'amplitude de sortie dépend de la valeur d'un mot de données numérique et dont la gamme d'amplitudes de sortie dépend de la valeur d'un courant de polarisation qui lui est amené, **caractérisé en ce**
**qu'**au moins un circuit (1) est prévu pour la production de courants de polarisation égalisés dont les valeurs peuvent varier en fonction d'au moins un premier mot de données,
**qu'**un circuit (11, 21, ...) pour le réglage de la gamme d'amplitudes de sortie qui est amenée à l'un des courants de polarisation égalisés, qui délivre un courant de polarisation pondéré pour le convertisseur numérique-analogique du type à courant (12, 22, ...) qui lui est affecté, est affecté à au moins un des convertisseurs numériques-analogiques du type à courant (12, 22, ...)
**qu'**un des courants de polarisation égalisés est amené aux convertisseurs numériques-analogiques du type à courant (12, 22) auxquels n'est affecté aucun circuit (11, 21, ...) pour le réglage de la gamme d'amplitudes de sortie,
**que** dans les circuits (11, 21,...) pour le réglage de la gamme d'amplitudes de sortie, le courant de polarisation égalisé qui lui est respectivement amené peut varier en fonction d'un deuxième mot de données qui lui est respectivement affecté de manière à former le courant de polarisation pondéré qui est amené au convertisseur numérique-analogique du type à courant respectivement affecté (12, 22,...).

2. Montage selon la revendication 1, **caractérisé en ce que**
le circuit (1) pour la production des courants de polarisation égalisés présente un amplificateur d'opération (31) à l'entrée non-inversante (32) duquel est amenée une tension de comparaison et en fonction du signal de sortie duquel sont produits les courants de polarisation égalisés et un courant de référence qui circule par une résistance de référence (2) dont la chute de tension est couplée à une entrée inversante (33) de l'amplificateur d'opération (31), des courants pondérés à monter sur le courant de référence en fonction d'un premier mot de données de commande pouvant être superposés pour l'égalisation des courants de polarisation égalisés, de préférence de même grandeur.

3. Montage selon la revendication 2, **caractérisé en ce**
**que** les miroirs de courant MOS (37, 38, 39, 44, 45, 46, 47) sont prévus et leurs courants de sortie pondérés peuvent être montés à l'aide de transistors MOS (40, 41, 48, 49) en fonction du premier mot de données de commande.

4. Montage selon l'une des revendications 2 ou 3 **caractérisé en ce**
**que** les courants pondérés à monter en fonction du premier mot de données de commande peuvent être superposés au courant de référence de même signe et/ou de signe différent.

5. Montage selon la revendication 1, **caractérisé en ce que** dans les circuits (11, 21....) de réglage de la gamme d'amplitude de sortie, le courant de polarisation égalisé respectivement amené est amené à un miroir de courant MOS (52, 53, 54, 55, 56) au sein duquel un transistor de sortie (54) délivre le courant de polarisation égalisé inchangé et au sein duquel sont prévus d'autres transistors de sortie (55, 56) qui délivrent en fonction d'un deuxième mot de données de commande respectivement affecté et de transistors MOS affectés (60, 61) des courants pondérés commutables qui sont superposés au courant de polarisation égalisé de manière à former le courant de polarisation pondéré qui est amené au convertisseur numérique-analogique du type à courant respectivement affecté (12, 22...).

6. Montage selon la revendication 1, **caractérisé en ce**
**qu'**un circuit (11, 21) de réglage de la gamme d'amplitudes de sortie est respectivement affecté à chacun des convertisseurs numériques-analogiques du type à courant et que les courants de polarisation égalisés ont les mêmes valeurs.

7. Montage selon la revendication 1, **caractérisé en ce**
**que** le premier mot de données de commande qui est amené au circuit (1) de production des courants de polarisation égalisés est prévu pour la correction des valeurs des courants de polarisation égalisés si ceux-ci diffèrent d'une valeur de consigne en raison des valeurs de la tension de référence et/ou de la résistance de référence (2) différant des valeurs de consigne..

8. Montage selon la revendication 1, **caractérisé en ce**
**que** les deuxièmes mots de données de commande de réglage affectés aux convertisseurs numériques-analogiques du type à courant (12, 22,...) ou les circuits affectés à ceux-ci (11, 21,...) pour le réglage de la gamme d'amplitudes de sortie sont prévus pour le réglage de gammes d'amplitudes qui sont respectivement affectées aux types de données que convertissent les convertisseurs numériques-analogiques du type à courant (12, 22, ...)

9. Montage selon la revendication 8, **caractérisé en ce**
**que** les deuxièmes mots de données de commande affectés aux convertisseurs numériques-analogiques du type à courant (12, 22, ... ) ou aux circuits (11, 21....) affectés à ceux-ci pour le réglage de la gamme d'amplitudes de sortie sont choisis de telle sorte que le convertisseur numérique-analogique du type à courant (12, 22, ...) respectivement affecté produise sur une résistance montée en aval une amplitude de tension de 1 volt en cas de traitement d'un signal RGB vidéo, une amplitude de tension de 1,16 volt en cas de traitement d'un signal Y/C vidéo et une amplitude de tension 1,23 volt en cas de traitement d'un signal CVBS vidéo.

10. Mise en oeuvre du montage selon l'une des revendications 1 à 9 de conversion numérique-analogique d'un signal d'image.
